# EUROPEAN PATENT APPLICATION

(11) **EP 4 592 796 A1**
(43) Date of publication of application: **30.07.2025**
(21) Application number: 23876411.2
(22) Date of filing: 06.09.2023
(51) Int. Cl.: G06F 1/18, H05K 7/20

(54) **COMPUTING DEVICE AND COMPUTING NODE**

(30) Priority: 11.10.2022 CN 202211242248
(71) Applicant: xFusion Digital Technologies Co., Ltd., Zhengzhou, Henan 450000 (CN)
(72) Inventor: WANG, Chenglong, Zhengzhou, Henan 450000 (CN); JIA, Hui, Zhengzhou, Henan 450000 (CN)
(74) Representative: MERH-IP Matias Erny Reichl Hoffmann Patentanwälte PartG mbB
(86) International application number: PCT/CN2023/117215
(87) International publication number: WO 2024/078206

(57) **Abstract**

Embodiments of the present application disclose a computing device and a computing node. A housing of the computing node includes a bottom shell and an upper cover. The upper cover and the bottom shell are adapted to form an accommodation cavity. A liquid cooling working medium is sprayed to a to-be-cooled component by a spray assembly. Based on heat dissipation by immersion liquid cooling, heat dissipation capability for a high-heat generating component is improved. A nozzle and a second joint of the spray assembly are disposed on the upper cover, and the second joint is in communication with the nozzle. A first joint of the spray assembly is located in the accommodation cavity and in communication with a working medium inlet. The first joint is located in the accommodation cavity and in communication with the working medium inlet. The first joint and the second joint are adaptable to form a mating and communicating assembly to deliver the cooling working medium from a side of the bottom shell to the nozzle. In this configuration, the working medium inlet and a working medium outlet for establishing a cooling working medium delivery path are arranged by making full use of a height dimension of the side of the bottom shell, reducing a thickness of the upper cover, and reasonably controlling a height dimension of the computing node. This configuration can be applied to different high-density deployment scenarios.

## Description

This application claims priority to Chinese Patent Application No. 202211242248.X, filed with the China National Intellectual Property Administration on October 11, 2022, and entitled "COMPUTING DEVICE AND COMPUTING NODE", which is incorporated herein by reference in its entirety.

### TECHNICAL FIELD

Embodiments of the present application relates to the field of computer hardware, and in particular, to a computing device and a computing node.

### BACKGROUND

In a high performance computing (HPC, High Performance Computing) cluster or cloud computing data center, multiple computing nodes are usually included in a cabinet to enhance the integration of products and reduce space occupation in the equipment room.

As the performance of the computing nodes improves, the power consumption of internal components of the computing nodes increases. In order to improve the PUE (Power Usage Efficiency, power usage efficiency) of the equipment operation, a conventional server node adopts a manner of heat dissipation by immersion liquid cooling. A mainboard and components inside the node are immersed in a cooling working medium, which absorbs the heat generated by the components. After completing the heat exchange, the cooling working medium is recirculated back into the computing node for the next liquid cooling cycle. For the components with high power consumption, complete immersion in the cooling working medium cannot meet their heat dissipation requirements. While increasing the amount of immersion liquid to enhance its heat dissipation capability would increase the space occupied by the computing node, making it impossible to reasonably balance product integration and heat dissipation requirements.

### SUMMARY

Embodiments of the present application provide a computing device and a computing node, to meet a heat dissipation requirement of an internal to-be-cooled component without increasing occupied space.

A first aspect of the embodiments of the present application provides a computing node, including a housing, a circuit board, and a spray assembly. The housing includes a bottom shell and an upper cover. The upper cover and the bottom shell are adapted to form an accommodation cavity. The accommodation cavity is configured for accommodating a cooling working medium. The bottom shell is provided with a working medium inlet and a working medium outlet. The working medium inlet and the working medium outlet are respectively communicated to external cooling working medium to establish a circulation of cooling working medium. The circuit board and the spray assembly are located in the accommodation cavity, and a component is provided on the circuit board. A to-be-cooled component can be immersed in the cooling working medium to form a mode of basic heat dissipation by immersion liquid cooling. In addition, the spray assembly is configured to spray the liquid cooling working medium to the to-be-cooled component. This allows for targeted spraying of the cooling working medium onto the to-be-cooled component, such as but not limited to, a processor with high power consumption, thereby effectively enhancing heat dissipation capability for a high-heat generating component based on heat dissipation by immersion liquid cooling. In this solution, the spray assembly includes a nozzle, a first joint, and a second joint. The nozzle and the second joint are disposed on the upper cover, the second joint is in communication with the nozzle. The first joint is located in the accommodation cavity and in communication with the working medium inlet. The first joint is located in the accommodation cavity and in communication with the working medium inlet. The first joint and the second joint are adaptable to form a mating and communicating assembly to deliver the cooling working medium from a side of the bottom shell to the nozzle. In this configuration, on the basis of meeting the heat dissipation requirement of the component, the working medium inlet and a working medium outlet for establishing a cooling working medium delivery path are arranged by making full use of a height dimension of the side of the bottom shell. The delivery of the cooling working medium is achieved by the mating and communicating assembly, reducing a thickness of the upper cover and reasonably controlling a height dimension of the computing node.

Based on the first aspect, the embodiments of the present application further provide a first implementation of the first aspect. The to-be-cooled component includes a first to-be-cooled component and a second to-be-cooled component, a power consumption of the first to-be-cooled component is higher than that of the second to-be-cooled component, and the spray assembly is configured to spray the liquid cooling working medium to the first to-be-cooled component. Alternatively, the spray assembly is configured to spray the liquid cooling working medium to a heat spreader of the first to-be-cooled component. In this way, based on the basic heat dissipation by immersion liquid cooling, the spray assembly is configured for a power component with a higher power consumption to meet its heat dissipation requirement, such as a processor with high heat generation in the computing node. Correspondingly, other component with lower power consumption in the computing node can meet its heat dissipation requirement only by the basic heat dissipation by immersion liquid cooling. Overall, heat dissipation capability of the basic heat dissipation by immersion liquid cooling is kept within a reasonable range, reducing the occupied space and lowering system configuration cost and operating cost.

In a specific application, the first to-be-cooled component may include one or more components, and the second to-be-cooled component may also include one or more components. Exemplarily, in a case where the first to-be-cooled component includes a plurality of components, the plurality of components may be the same type or different types. For example, the plurality of components are processors, or the plurality of components include processors and memory modules.

Based on the first aspect or the first implementation of the first aspect, the embodiments of the present application further provide a second implementation of the first aspect. The upper cover is plate-like. On the basis of meeting a structural function of the upper cover, a thickness dimension of the upper cover is minimized to the greatest extent to provide technical support for further controlling the height dimension of the computing node.

Based on the second implementation of the first aspect, the embodiments of the present application further provide a third implementation of the first aspect. An inner surface of the upper cover is provided with a reinforcing rib, and the nozzle, the second joint, and a pipeline component communicating the nozzle and the second joint are embedded on the reinforcing rib. In this configuration, the assembly and fixation of the components are achieved by using a structural thickness of the reinforcing rib, reducing an occupied height space.

Based on the second implementation of the first aspect, or the third implementation of the first aspect, the embodiments of the present application further provide a fourth implementation of the first aspect. The reinforcing rib is arranged crosswise in a grid-shape, and the pipeline component includes pipes and a fitting, and the fitting is communicated between the pipes. Accordingly, the reinforcing rib includes a plurality of recesses, the plurality of recesses are configured for the spray assembly, the second joint, and the fitting to be embedded therein, respectively, and the reinforcing rib between the plurality of recesses includes pipe slots configured for the corresponding pipes to be embedded therein. The structure is simple and reliable.

In a specific application, each of the recesses has a mounting step. The nozzle, the second joint, and the fitting are detachably connected to the corresponding mounting step, and the nozzle, the second joint, and the fitting are flush with a surface of the reinforcing rib. Exemplarily, the nozzle, the second joint, and the fitting can be respectively assembled and fixed to the corresponding mounting step by using threaded fasteners. As a foundation structure for the assembly and fixation, the mounting steps are located on the reinforcing rib without providing the foundation structure by increasing the thickness of the upper cover.

Based on the first aspect, or the first implementation of the first aspect, or the second implementation of the first aspect, or the third implementation of the first aspect, or the fourth implementation of the first aspect, the embodiments of the present application further provide a fifth implementation of the first aspect. One of the first joint and the second joint includes a convex connection portion, and the other of the first joint and the second joint includes a concave connection portion, and the convex connection portion is capable of being inserted into the concave connection portion to mate and communicate with each other. In other words, by constructing the mating and communicating assembly with these two portions, the cooling working medium can be delivered from the side of the bottom shell to a side of the upper cover.

Based on the fifth implementation of the first aspect, the embodiments of the present application further provide a sixth implementation of the first aspect. A sealing element is provided between the convex connection portion and the concave connection portion. In this way, after the insertion of the second joint and the first joint is completed, a sealing relationship is simultaneously formed between the first joint and the second joint, realizing more favorable manufacturability.

Based on the fifth or sixth implementation of the first aspect, the embodiments of the present application further provide a seventh implementation of the first aspect. One of the first joint and the second joint includes a positioning rod, and the other of the first joint and the second joint includes a guide hole, the positioning rod is capable of being inserted into the guide hole; a spacing between an end of the positioning rod and an edge of the guide hole is less than a spacing between an end of the convex connection portion and an edge of the concave connection portion. During actual assembly, pre-positioning between the first joint and the second joint is achieved through the adapted positioning rod and guide hole, and then the insertion is continued to achieve the mating and communicating between the convex connection portion and the concave connection portion. This configuration prevents an operation force from being applied to the convex connection portion and the concave connection portion when they are not fully aligned, thereby avoiding unnecessary insertion loss and further improving the manufacturability.

In a specific application, the end of the positioning rod may have a guiding tapered surface to provide effective guidance at the initial stage of insertion to quickly achieve alignment during assembly.

Based on the first aspect, or any one of the first, second, third, fourth, fifth, sixth, or seventh implementations of the first aspect, the embodiments of the present application further provide an eighth implementation of the first aspect. The nozzle includes a nozzle body and a fixing body, the nozzle body is provided with spray holes, and is detachably connected to the fixing body, for example, but not limited to, using a threaded structure to realize the detachable connection. The fixing body is used to be connected and fixed to the upper cover. For different application scenarios, based on the fixing body with a same dimension structure, it is sufficient to configure the nozzle body which meets an actual heat dissipation requirement. In this way, configurations of some parts are standardized, and cost of product design and manufacturing management are reasonably controlled.

Based on the first aspect, or any one of the first, second, third, fourth, fifth, sixth, seventh, or eighth implementations of the first aspect, the embodiments of the present application further provide a ninth implementation of the first aspect. A switch valve is provided in a communication path between the first joint and the working medium inlet.

Exemplarily, the switch valve may be an electrically controlled valve, and a start/stop operation is performed by a control instruction output by a controller. In a specific application, based on a liquid level change of the cooling working medium in the bottom shell and/or actual heat dissipation performance of the to-be-cooled component corresponding to each spray assembly, the controller determines a current actual working condition and outputs the control instruction for controlling the starting or stopping of the switch valve. In other applications, the controller may also comprehensively determine the actual heat dissipation performance of each component of the computing node and adjust an opening degree of the switch valve to achieve actual required heat dissipation capability for a current operating condition by balancing input flow of the cooling working medium.

A second aspect of the embodiments of the present application provides a computing device, including at least one computing node as described above. In this configuration, in addition to meeting heat dissipation requirement of the component in the computing node, the height dimension of the computing node can be reasonably controlled, reducing the occupied space, and meeting the requirement of high-density deployment design trend.

In a specific application, the computing device may be a type of product such as a computer, server, or edge device.

### BRIEF DESCRIPTION OF DRAWINGS

FIG. 1 is a schematic diagram of a computing node according to an embodiment of the present application;
FIG. 2 is an exploded perspective view of an assembly of another computing node according to an embodiment of the present application;
FIG. 3 is a schematic diagram of an assembling relationship of a nozzle on an upper cover shown in FIG. 2;
FIG. 4 is a schematic diagram of a communication relationship of a pipeline component between the nozzle and a second joint of a spray assembly shown in FIG. 3;
FIG. 5 is an exploded perspective view of an assembly of the upper cover, the nozzle, and the pipeline component shown in FIG. 3;
FIG. 6 is an enlarged view of part I of FIG. 3;
FIG. 7 is an enlarged view of part II of FIG. 3;
FIG. 8 is an enlarged view of part III of FIG. 3;
FIG. 9 is an enlarged view of part IV of FIG. 2;
FIG. 10 is a cross-sectional view of a communication relationship of a second joint shown in FIG. 8;
FIG. 11 is a cross-sectional view of an assembling relationship of a first joint and a second joint according to an embodiment of the present application; and
FIG. 12 is a cross-sectional view of an assembling relationship of the nozzle shown in FIG. 6.

### DESCRIPTION OF EMBODIMENTS

Embodiments of the present application provide a computing node, which meets a heat dissipation requirement of a high-power consumption component without increasing occupied height space.

As performance of computing nodes improves, power consumption of their internal components increases. To improve the PUE (Power Usage Efficiency, power usage efficiency) index of device operation, a conventional server node adopts a manner of heat dissipation by immersion liquid cooling. A circuit board, such as a mainboard, and a component inside the computing node are immersed in a cooling working medium, and the cooling working medium absorbs heat generated by the component. After completing heat exchange, the cooling working medium is recirculated back into the computing node for the next liquid cooling cycle. It can be understood that, during operation of the computing node, actual heat generation of various internal components, including high-power consumption components, is different. The liquid cooling cycle that meets heat dissipation requirement of other relatively low-power consumption components may not meet the heat dissipation requirement of the high-power consumption components. Configuring heat dissipation capability of the immersion liquid cooling for the component with high power consumption, such as but not limited to, increasing amount of immersion liquid, would increase space occupied by the computing node, directly affecting product integration.

Based on the above, embodiments of the present application provide a computing node. The computing node includes a sealed housing. The sealed housing includes a bottom shell and an upper cover. The bottom shell includes a cavity with a top opening, and the upper cover and the top opening of the bottom shell are adapted to enclose to form an internal accommodation cavity. The accommodation cavity is configured to accommodate a cooling working medium. The bottom shell is provided with a working medium inlet and a working medium outlet. The working medium inlet and the working medium outlet are respectively communicated to external cooling medium to establish a circulation of the cooling working medium. A circuit board and a spray assembly are located in the accommodation cavity, and the circuit board is provided with a component thereon to form a mode of basic heat dissipation by immersion liquid cooling. In addition, the computing node also includes the spray assembly for spraying the cooling working medium to at least part of a to-be-cooled component. This allows for targeted spraying of the cooling working medium onto the at least part of the to-be-cooled component, such as but not limited to, a processor with high power consumption, thereby effectively enhancing heat dissipation capability for a high-heat generating component based on heat dissipation by immersion liquid cooling.

The spray assembly includes a nozzle, a first joint, and a second joint. The second joint is disposed on the upper cover. The second joint is in communication with the nozzle. The first joint is located in the accommodation cavity and in communication with the working medium inlet, and the first joint is located in the accommodation cavity and in communication with the working medium inlet. The first joint and the second joint can be adapted to form a mating and communicating assembly to deliver the cooling working medium from a side of the bottom shell to the nozzle. Based on the working medium inlet, both pre-filling of the cooling working medium and supply of liquid volume for targeted spraying of the cooling working medium are achieved. In this solution, the working medium inlet and the working medium outlet for establishing a cooling working medium delivery path are arranged by making full use of a height dimension of the side of the bottom shell. The delivery of the cooling working medium is achieved by the mating and communicating assembly, reducing a thickness of the upper cover and reasonably controlling a height dimension of the computing node.

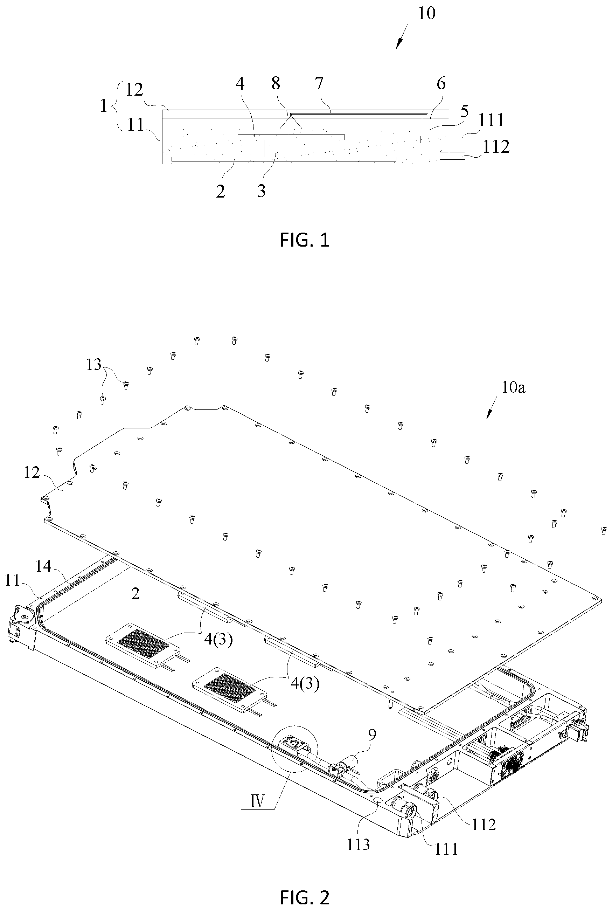

To better understand a technical solution and technical effect of the present application, and without losing generality, the following describes the embodiments of the present application in detail with reference to the accompanying drawings, taking a server as a main body and a mainboard as a typical application of a circuit board. As shown in FIG. 1, FIG. 1 is a schematic diagram of the computing node. A mainboard 2 of the computing node 10 and a component disposed on the mainboard 2 are disposed inside a sealed housing 1, and the sealed housing 1 is pre-filled with a cooling working medium. A to-be-cooled component is immersed in the cooling working medium. Heat exchange occurs through contact between a surface of the component and the cooling working medium, and heat is removed based on a working cycle of the cooling working medium, thereby forming the basic heat dissipation by immersion liquid cooling.

Here, the to-be-cooled component includes a power component that generates heat during operation in the computing node 10, and a component such as a heat spreader 4, which is in contact with the power component such as a processor 3. To simplify the drawing and clearly illustrate the constitution and correlation of heat dissipation function of this implementation, only the processor 3 is shown as the power component on the mainboard 2 in the drawing. It should be understood that the mainboard 2 may also include other power components, such as but not limited to, memory modules.

The housing 1 includes an adaptable bottom shell 11 and an upper cover 12. The mainboard 2 and the component on the mainboard 2 are all located in the internal cavity of the bottom shell 11, and the upper cover 12 and the top opening of the bottom shell 11 are adapted to enclose to form an internal sealed space. A height dimension of the bottom shell 11 meets a requirement for assembly of the mainboard 2 and the component thereon, and the achievement of the immersion liquid cooling heat dissipation function. It should be understood that the housing should meet a basic sealing requirement of an internal cooling working medium. The specific structural implementation of the housing is not the core of the present application, so it is not described in detail herein.

A working medium inlet 111 and a working medium outlet 112 configured to establish a cooling working medium cycle are disposed on the bottom shell 11, making full use of the height dimension of the bottom shell 11, avoiding the situation where structures such as the working medium inlet and working medium outlet are disposed on the upper cover 12, which would thicken the upper cover 12 and overall thickness dimension of the node.

In this implementation, a first joint 5 in communication with the working medium inlet 111 is provided on the bottom shell 11, and a second joint 6 in communication with a pipeline component 7 is provided on the upper cover 12. Herein, the first joint 5 and the second joint 6 may be adapted to form a mating and communicating assembly, allowing the cooling working medium to be delivered from the side of the bottom shell to a side of the upper cover, and then to a nozzle 8 through the pipeline component 7. This enables targeted spraying of the cooling working medium onto the processor 3 and its heat spreader 4, improving contact heat exchange efficiency. In this way, based on the immersion liquid cooling heat dissipation, heat dissipation capability for the processor 3 can be effectively improved.

Specifically, the nozzle 8 can spray the cooling working medium towards the heat spreader 4. Based on a rapid heat dissipation characteristic of the heat spreader 4, heat generated by the processor 3 during operation can be quickly removed. It should be understood that specific functional structure of the heat spreader 4 can be implemented using a related art, so it is not described in detail herein.

In addition, after completing assembly of the upper cover 12 and the bottom shell 11, the second joint 6 on the upper cover 12 can be mated and communicated with the first joint 5 on the bottom shell 11. The mating and communicating assembly does not require additional assembly space, making the structure simple and easy to implement.

It should be noted that, to balance different heat dissipation requirements of various to-be-cooled components in the computing node, based on the basic heat dissipation by immersion liquid cooling, the nozzle can be configured for the power component with high power consumption to meet its heat dissipation requirement, such as the processor with high heat generation in the computing node. Accordingly, other component with lower power consumption in the computing node can meet its heat dissipation requirement only by the basic heat dissipation by immersion liquid cooling. In other words, a part of the to-be-cooled components are cooled by the basic heat dissipation by immersion liquid cooling, and another part of the to-be-cooled components are cooled by spraying the working medium on the basis of heat dissipation by immersion liquid cooling. In this way, heat dissipation capability of the basic heat dissipation by immersion liquid cooling can be further controlled within a reasonable range, reducing occupied space and reducing system configuration cost and operating cost.

In a specific implementation, the part of the to-be-cooled components, that are cooled by the basic heat dissipation by immersion liquid cooling, includes one or more components. Another part of the to-be-cooled components, that are cooled by spraying the working medium on the basis of heat dissipation by immersion liquid cooling, includes one or more components.

As shown in FIG. 2, FIG. 2 is an exploded perspective view of an assembly of another computing node according to an embodiment of the present application. To clearly illustrate differences and connections between this embodiment and the embodiment shown in FIG. 1, components or structures with a same function are indicated by a same reference numeral in the drawings.

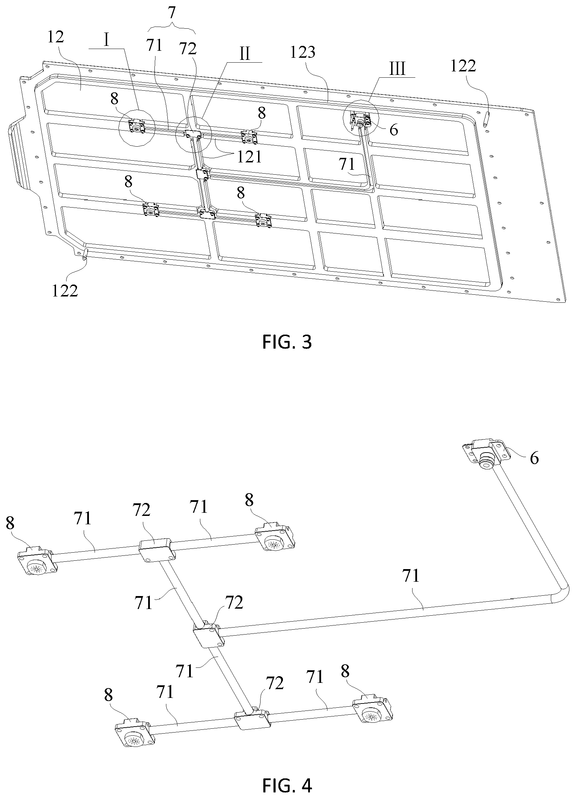

As shown in FIG. 2, the main body of the upper cover 12 of a computing node 10a adopts a plate structure and is fixedly connected to a side wall on the periphery of the top opening of the bottom shell 11 by threaded fasteners 13. In other specific implementations, a detachable connection between the upper cover 12 and the bottom shell 11 may also be achieved by using buckles or other methods. Based on a structural characteristic of the plate-like upper cover 12, an overall height of the computing node 10a is primarily determined by height dimension of the side of the bottom shell 11 and is not affected by a thickness dimension of the upper cover 12. In this implementation, nozzles 8 are respectively provided for heat spreaders 4 of a plurality of processors 3. As shown in FIG. 3, FIG. 3 is a schematic diagram of an assembling relationship of the nozzle on the upper cover shown in FIG. 2.

The working medium inlet 111 for inflow of the cooling working medium and the working medium outlet 112 for outflow of the cooling working medium are both disposed on a same side of the bottom shell 11. In addition, an electric interface such as a high-speed cable end and a power end may also be disposed on the same side of the bottom shell, so as to facilitate disassembly and assembly by an operator. In a specific implementation, both the working medium inlet 111 and the working medium outlet 112 can be in a form of quick-connect joints. During assembly, the computing node 10a can be mated to a pipeline of the system after being inserted in place, and the working cycle of the cooling working medium can be quickly established.

As shown in the drawing, the computing node 10a includes four processors 3, each of the processors 3 is matched and equipped with the heat spreader 4, and four nozzles 8 are correspondingly provided.

In this embodiment, the four nozzles 8 are disposed in one-to-one correspondence with the four heat spreaders 4. In other words, each nozzle 8 provides liquid working medium flow to a corresponding heat spreader 4. The "corresponding" disposition here means that the corresponding to-be-cooled component is located within the spray range of the liquid working medium flow sprayed by the nozzles 8, but is limited to referring to their relative position in a height direction.

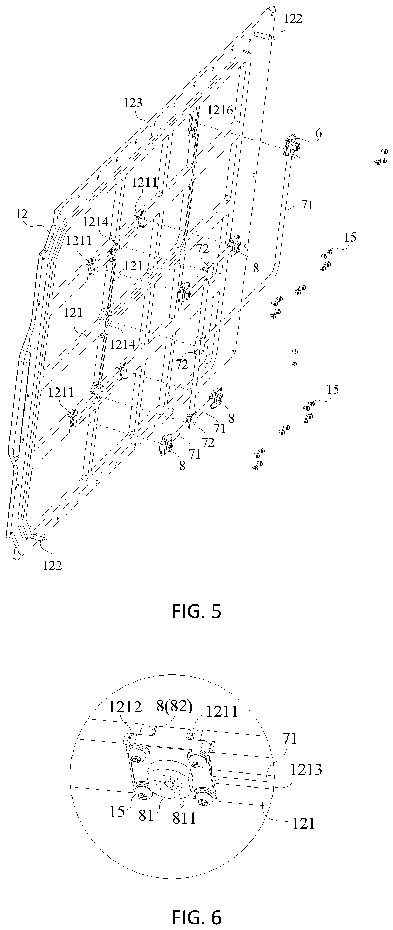

The four nozzles 8 are respectively in communication with the second joint 6 through the pipeline component 7. As shown in FIGS. 3, 4, and 5, FIG. 4 is a schematic diagram of a communication relationship of the pipeline component between the nozzles and the second joint shown in FIG. 3. FIG. 5 is an exploded perspective view of an assembly of the upper cover, the nozzles of the spray assembly, and the pipeline component shown in the drawing.

Specifically, the pipeline component 7 includes pipes 71 and a fitting 72 disposed at a connection position between the pipes 71. As shown in the drawing, the second joint 6, each fitting 72, and a body of each nozzle 8 may be fixed on the upper cover 12 by threaded fasteners, thereby being preassembled on the upper cover 12.

As shown in FIG. 3 again, an inner surface of the upper cover 12 is provided with a reinforcing rib 121 which is arranged crosswise in a grid-shape. The rigidity of the upper cover 12 can be effectively improved by arranging the reinforcing rib 121. In a specific implementation, the upper cover 12 may be formed using an aluminum alloy die-casting process.

Based on arrangement of the reinforcing rib 121, the second joint 6, the pipeline component 7, and each nozzle 8 in this solution are embedded on the reinforcing rib 121. A structural thickness of the reinforcing rib 121 is used to achieve assembly and fixation of each component.

As shown in FIG. 6, FIG. 6 is an enlarged view of part I of FIG. 3, specifically illustrating an assembling relationship of the nozzle 8 with the reinforcing rib 121 where the nozzle is located. The reinforcing rib 121 includes a first recess 1211 adapted to the nozzle 8, and the first recess 1211 has a first mounting step 1212. A body of the nozzle 8 is fixed on the first mounting step 1212 by a threaded fastener 15. After assembly, the nozzle 8 is substantially flush with a surface of the reinforcing rib 121, and a thickness dimension of the reinforcing rib is used to achieve assembly and fixation of the nozzle, reducing an occupied height space. The "substantially flush" herein allows for a certain deviation within a range allowed by a precision of processing and assembly, rather than specifying a situation of complete alignment.

In addition, the reinforcing rib 121 where the nozzle 8 is located also includes a pipe slot 1213. The pipe slot 1213 extends through to the first recess 1211 and is configured for a pipe 71 connected to the nozzle 8 to be embedded therein and to accommodate a pipe 71 connected to the nozzle 8.

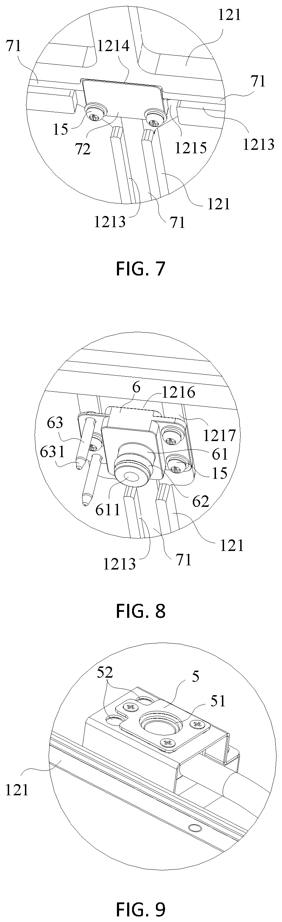

As shown in FIG. 7, FIG. 7 is an enlarged view of part II of FIG. 3, specifically illustrating an assembling relationship of the fitting 72 with the reinforcing rib 121 where the fitting is located. The fitting 72 can be used to communicate a pipe of a cooling working medium source side with two nozzles 8, and has three communication interfaces. Here, the pipe of the cooling working medium source side refers to a pipe connected to the fitting 72 and connected to the second joint 6. At an intersection of the reinforcing ribs 121, there is a second recess 1214 adapted to the fitting 72. The second recess 1214 has a second mounting step 1215, and a body of the fitting 72 is fixed on the second mounting step 1215 by the threaded fastener 15. After assembly, the fitting 72 is substantially flush with the surface of each reinforcing rib 121.

In other specific implementations, the fitting may also be configured to communicate with more than two nozzles 8. For example, when communicating the pipe of the cooling working medium source side with three nozzles 8, the fitting needs to be configured with four communication interfaces. This rule is also analogously applied to a situation where a plurality of nozzles are communicated. It can be understood that, based on the reinforcing rib 121 arranged crosswise in a grid-shape, the reinforcing rib 121 at the intersection is determined to according to a quantity of the connection interfaces for the corresponding fitting. This allows the second recess at the intersection to be used for achieving assembly and fixation of the fitting.

As shown in FIG. 3 again, each of the nozzles 8, the fitting 72, and the pipes 71 are embedded on the corresponding reinforcing rib 121, and a reliable assembly and fixation relationship is achieved based on the reinforcing rib 121. In this configuration, on the one hand, the reinforcing rib 121 prevents deformation of the plate-like upper cover 12, while also provides an assembly and adapting structure for the nozzles 8 and the pipeline component 7 without increasing the thickness of the upper cover 12. It features a simple structure and easiness in process realization.

As shown in FIG. 8, FIG. 8 is an enlarged view of part III of FIG. 3, specifically illustrating an assembling relationship of the second joint 6. Similarly, the pipe 71 connected to the second joint 6 is embedded in the pipe slot 1213 of the reinforcing rib 121 where the pipe 71 is located. The reinforcing rib 121 includes a third recess 1216 adapted to the nozzle 8, and the third recess 1216 has a third mounting step 1217. A body of the second joint 6 is fixed on the third mounting step 1217 by the threaded fastener 15. After assembly, the second joint 6 may not protrude from the surface of the reinforcing rib 121.

It can be understood that the nozzle 8, each fitting 72, and the second joint 6 in this solution are all connected to the corresponding mounting step by the threaded fasteners. In other specific implementations, a buckle adapter structure may also be used to form a detachable connection with the mounting step of the corresponding recess, respectively.

In this embodiment, the first joint 5, which is adapted to the second joint 6, is disposed on the bottom shell 11. As shown in FIGS. 2 and 9, FIG. 9 is an enlarged view of part IV of FIG. 2.

As shown in FIGS. 8 and 9, the second joint 6, which is disposed on the upper cover 12, includes a convex connection portion 61, and the first joint 5, which is disposed on the bottom shell 11, includes a concave connection portion 51. When the upper cover 12 and the bottom shell 11 are closed and assembled, the convex connection portion 61 of the second joint 6 may be inserted into the concave connection portion 51 of the first joint 5. By constructing the mating and communicating assembly with these two portions, the cooling working medium is delivered from the side of the bottom shell to the side of the upper cover.

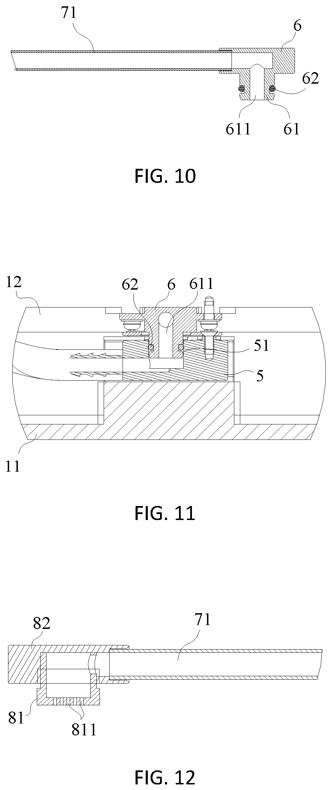

In this embodiment, the convex connection portion 61 is provided with a central through-hole 611 which is in communication with an inner cavity of the joint. As shown in FIGS. 10 and 11, FIG. 10 is a cross-sectional view of a communication relationship of the second joint 6 shown in FIG. 8, and FIG. 11 is a cross-sectional view of an assembling relationship of the first joint and the second joint. Accordingly, the concave connection portion 51 of the first joint 5 and an inlet thereof are communicated with each other, and after the two are mated, the delivery of the cooling working medium between the side of the bottom shell and the side of the upper cover is achieved.

In addition, a first sealing ring 62 is provided on an outer periphery of the convex connection portion 61 of the second joint 6. When the convex connection portion 61 of the second joint 6 is inserted into the concave connection portion 51 of the first joint 5, the first sealing ring 62 is radially compressed and deformed, and a reliable seal is formed between the two joints. In other words, after the insertion of the second joint 6 and the first joint 5 is completed, a sealing relationship is formed, realizing more favorable manufacturability.

In a specific implementation, the above sealing relationship may also be achieved using sealing elements of other structural forms, such as, but not limited to, a sealing element (not shown in the drawings) that is axially compressed and deformed between the adapted first joint 5 and the second joint 6. When the convex connection portion 61 of the second joint 6 is inserted into the concave connection portion 51 of the first joint 5, this sealing element is axially compressed and deformed, similarly forming the reliable seal between the two joints.

In other specific implementations, the mating and communicating assembly may employ a different adapting structure to achieve a working medium delivery function. As an example and not by way of limitation, the adapted convex connection portion and the concave connection portion may be reversely disposed, that is to say, the convex connection portion is disposed on the first joint, and correspondingly, the concave connection portion is disposed on the second joint. The above established function of mating and communicating can also be achieved similarly.

Furthermore, to further improve the manufacturability, an adaptable pair of positioning and guiding elements is provided between the second joint 6 and the first joint 5. As shown in FIGS. 8 and 9, the second joint 6 is provided with two first positioning rods 63. Correspondingly, the first joint 5 is provided with two first guide holes 52. The first positioning rods 63 can be inserted into the corresponding first guide holes 52 to ensure that the convex connection portion 61 of the second joint 6 and the concave connection portion 51 of the first joint 5 are inserted and aligned.

Here, a spacing between an end of the first positioning rod 63 and an edge of the first guide hole 52 may be less than a spacing between an end of the convex connection portion 61 and an edge of the concave connection portion 51. The pair of positioning and guiding elements constructed by the first positioning rod 63 and the first guide hole 52 provides a guiding and positioning function. In other words, during actual assembly, pre-positioning between the first joint 5 and the second joint 6 is achieved through the adapted first positioning rod 63 and the first guide hole 52, and then the insertion is continued to achieve the mating and communicating between the convex connection portion 61 and the concave connection portion 51. In a specific implementation, the adapted first positioning rod 63 and the first guide hole 52 are not limited to the two shown in the drawing, while they may be configured as one or more rods or holes according to an actual assembly space of a product.

This configuration prevents an operation force from being applied to the convex connection portion 61 and the concave connection portion 51 when they are not fully aligned, thereby avoiding unnecessary insertion loss and further improving the manufacturability. In addition, bottom ends of the two first positioning rods 63 may have guiding tapered surfaces 631 to provide effective guidance at an initial stage of insertion to quickly achieve alignment during assembly.

For the pipeline component 7 disposed on the upper cover 12, a reliable sealing connection is required for a communication relationship formed by constituent parts of the pipeline component 7. Specifically, the assembly and fixation between the second joint 6 and the pipes 71, as well as between each fitting 72 and the corresponding pipes 71 may be achieved through welding or adhesion, which can be determined based on material of a substrate. There is no specific limitation here.

In addition, an aperture and an arrangement density of spray holes 811 of the nozzle 8 should be determined by comprehensively considering the operating heat generation of the to-be-cooled component, as well as liquid supply pressure and flow. In this implementation, the nozzle 8 adopts a split structure design, with a nozzle body 81 detachably connected to a fixing body 82. As shown in FIG. 12, FIG. 12 is a cross-sectional view of an assembling relationship of the nozzle 8 shown in FIG. 6.

In a specific implementation, the nozzle body 81 may adopt a threaded structure or a snap-fit structure to establish a detachable connection with the fixing body 82 and form an internal communication. The fixing body 82 is also used to connect with and fix on an assembly structure of the upper cover. For different application scenarios, based on the fixing body 82 with a same dimension structure, it is sufficient to configure the nozzle body which meets an actual heat dissipation requirement. In this way, configurations of some parts are standardized, and cost of product design and manufacturing management are reasonably controlled. As shown in FIG. 12, an assembly and fixation between the fixing body 82 and the pipe 71 may also be achieved through welding or adhesion.

To prevent the internal cooling working medium from escaping, as shown in FIG. 2, a second sealing ring 14 is embedded on a top surface of a side wall of the bottom shell 11. As each threaded fastener 13 is tightened, the second sealing ring 14 deforms under a pressure of the upper cover 12, establishing a reliable sealing relationship between the upper cover 12 and the bottom shell 11.

In other specific implementations, the above sealing relationship may also be achieved using other types of sealing elements. As an example and not by way of limitation, an outer seam 123 may be formed based on the reinforcing rib 121 arranged crosswise in the grid-shape. An outer peripheral surface of the seam 123 may be adapted to an inner surface of the top opening of the bottom shell 11. A sealing element (not shown in the drawings) is provided between the seam 123 and the inner surface of the top opening, which also provides a reliable seal after assembly.

In addition, to facilitate an assembly operation between the upper cover 12 and the bottom shell 11, the upper cover 12 is provided with a second guide rod 122, and the bottom shell 11 is correspondingly provided with a second guide hole 113. When the upper cover 12 is assembled, the second guide rod 122 thereon is first inserted into the second guide hole 113 on the bottom shell 11 to provide basic positioning and guiding for the assembly of the sealed housing, facilitating the quick assembly operation.

Furthermore, in this implementation, a switch valve 9 is provided in a communication path between the working medium inlet 111 and the first joint 5. In a specific implementation, the switch valve 9 may be an electrically controlled valve, and a start/stop operation is performed by a control command issued by a controller.

Specifically, based on a liquid level change of the cooling working medium in the bottom shell 11 and/or actual heat dissipation performance of the to-be-cooled component corresponding to each nozzle 8, the controller evaluates a current actual operating condition and issues the control command to start or stop the switch valve 9. In other implementations, the controller may also comprehensively evaluate the actual heat dissipation performance of each component of the computing node and adjust an opening degree of the switch valve 9 to achieve actual required heat dissipation capability for a current operating condition by balancing input flow of the cooling working medium.

It should be noted that, typically, the processor is a highest power-consuming component on the mainboard, and a server heat dissipation solution needs to primarily focus on the heat dissipation processing capability of the processor. To clearly explain the heat dissipation solution provided by the present application for the components on the circuit board, the embodiments described in FIGS. 1 and 2 take the processor as an example of a heat-generating component. In an actual application, the processor may be replaced by any other one or more heat-generating components. Examples include, but not limited to, memory modules, riser cards, or other to-be-cooled components.

It can be understood that the nozzle 8 should have a specific primary spray target. In a specific implementation, a coverage area of an actual spray amplitude of each nozzle may be limited to the primary spray target only, or may be designed to cover a plurality of heat-generating components according to an actual scheme design, rather than being restricted to the single specific spray target. In addition, in other specific implementations, for the particular spray target, one nozzle as shown in the drawing may be configured for spraying and heat dissipation, or a plurality of nozzles may be configured for spraying simultaneously to achieve better heat dissipation efficiency.

For the embodiments described in FIGS. 1 and 2, the computing node (10, 10a) may adopt a single-phase cooling working medium to achieve heat dissipation by immersion liquid cooling. After a low-temperature liquid cooling working medium completes heat exchange with the to-be-cooled component, a high-temperature liquid cooling working medium will flow out through the working medium outlet 112. After completing the heat exchange by a heat exchange device of the single-phase liquid cooling cycle, the low-temperature liquid cooling working medium is then delivered into the housing 1 through the working medium inlet 111 for the next working cycle. In addition, for the embodiments described in FIGS. 1 and 2, the computing node (10, 10a) may also adopt a two-phase cooling working medium to achieve the heat dissipation by immersion liquid cooling. When the to-be-cooled component is working, the liquid cooling working medium is heated, and then absorbs the heat and vaporizes at a surface of the to-be-cooled component. The vapor cooling working medium will flow out through the working medium outlet 112, and an opening position of the working medium outlet 112 can be adjusted according to an actual situation. The vapor cooling working medium is condensed into a liquid state through a condensing device of the two-phase liquid cooling cycle. Then the liquid cooling working medium is delivered into the housing 1 through the working medium inlet 111 for the next working cycle.

For the heat dissipation method by immersion liquid cooling based on the single-phase or two-phase cooling working medium, its specific functional configuration can be achieved using the related art, so it is not described in detail here.

The computing node described in the above embodiments may be widely used in a high-density application scenario such as, but not limited to, a supercomputer, an HPC (High Performance Computing, high performance computing) cluster, and an intensive computing server.

The embodiments of the present application also provide a computing device that includes the computing node with the circuit board, and the circuit board is at least configured with the processor. The computing node adopts the computing node described in FIGS. 1 to 12 to meet the heat dissipation requirement of the high-power consumption component without increasing the occupied height space. In a specific application, the computing device may be the server as above described, or an edge device that includes the circuit board and provides an entrance to a core network for an enterprise or a service provider. The edge device includes, but not limited to, a router, a routing switch, an IAD (integrated access device, Integrated Access Device), a multiplexer, and a plurality of Metropolitan Area Network (MAN) and Wide Area Network (WAN) access devices. In addition, the computing device may also be a personal computer (personal computer, PC).

It should be understood that any other functional configuration of the corresponding computing device is not the core of the present application, so it is not described in detail here.

The above are only preferred implementations of the present application. It should be noted that for those skill in the art, a plurality of improvements and modifications can be made without departing from the principles of the present application. These improvements and modifications should also be considered to be within the protection scope of the present application.

## Claims

1. A computing node, comprising: a housing, a circuit board, and a spray assembly;
the housing comprising a bottom shell and an upper cover, wherein the upper cover and the bottom shell are adapted to form an accommodation cavity for accommodating a cooling working medium, the bottom shell is provided with a working medium inlet and a working medium outlet, the circuit board and the spray assembly are located in the accommodation cavity, and a component is provided on the circuit board; and
wherein the spray assembly is configured to spray the liquid cooling working medium to a to-be-cooled component, and the spray assembly comprises a nozzle, a first joint and a second joint, the nozzle and the second joint are disposed on the upper cover, the second joint is in communication with the nozzle; the first joint is located in the accommodation cavity and in communication with the working medium inlet, and the first joint and the second joint are adaptable to form a mating and communicating assembly to deliver the cooling working medium from a side of the bottom shell to the nozzle.

2. The computing node according to claim 1, wherein the to-be-cooled component comprises a first to-be-cooled component and a second to-be-cooled component, a power consumption of the first to-be-cooled component is higher than that of the second to-be-cooled component, and the spray assembly is configured to spray the liquid cooling working medium to the first to-be-cooled component.

3. The computing node according to claim 1 or 2, wherein the upper cover is plate-like.

4. The computing node according to claim 3, wherein an inner surface of the upper cover is provided with a reinforcing rib, and the nozzle, the second joint, and a pipeline component communicating the nozzle and the second joint are embedded on the reinforcing rib.

5. The computing node according to claim 4, wherein the reinforcing rib is arranged crosswise in a grid-shape, and the pipeline component comprises pipes and a fitting, and the fitting is communicated between the pipes; the reinforcing rib comprises a plurality of recesses, the plurality of recesses are configured for the nozzle, the second joint, and the fitting to be embedded therein, respectively, and the reinforcing rib between the plurality of recesses comprises pipe slots configured for the corresponding pipes to be embedded therein.

6. The computing node according to claim 5, wherein each of the recesses has a mounting step, and the nozzle, the second joint, and the fitting are detachably connected to the corresponding mounting step, and the nozzle, the second joint, and the fitting are flush with a surface of the reinforcing rib.

7. The computing node according to any one of claims 1 to 6, wherein one of the first joint and the second joint comprises a convex connection portion, and the other of the first joint and the second joint comprises a concave connection portion, and the convex connection portion is capable of being inserted into the concave connection portion to mate and communicate with each other.

8. The computing node according to claim 7, wherein a sealing element is provided between the convex connection portion and the concave connection portion.

9. The computing node according to claim 7 or 8, wherein one of the first joint and the second joint comprises a positioning rod, and the other of the first joint and the second joint comprises a guide hole, the positioning rod is capable of being inserted into the guide hole; a spacing between an end of the positioning rod and an edge of the guide hole is less than a spacing between an end of the convex connection portion and an edge of the concave connection portion.

10. The computing node according to any one of claims 1 to 9, wherein the nozzle comprises a nozzle body and a fixing body, wherein the nozzle body is provided with spray holes, and is detachably connected to the fixing body, and the fixing body is connected to the upper cover.

11. The computing node according to any one of claims 1 to 10, wherein a switch valve is provided in a communication path between the first joint and the working medium inlet.

12. A computing device, comprising at least one computing node according to any one of claims 1 to 11.

13. The computing device according to claim 12, wherein the computing device is a server.
